# EUROPEAN PATENT APPLICATION

(11) **EP 4 675 286 A1**
(43) Date of publication of application: **07.01.2026**
(21) Application number: 24186701.9
(22) Date of filing: 05.07.2024
(51) Int. Cl.: G01R 27/16, G01R 27/20, G01R 31/36, G01R 31/66

(54) **METHOD AND COMPUTER SYSTEM FOR DIAGNOSING AN ELECTRICAL CONNECTION WITHIN AN ELECTRICAL ENERGY STORAGE PACK**

(71) Applicant: VOLVO TRUCK CORPORATION, 405 08 Göteborg (SE)
(72) Inventor: DEVARA MANE, Manjunath, 418 32 GÖTEBORG (SE)
(74) Representative: Kransell & Wennborg KB

(57) **Abstract**

A computer system (100) for diagnosing an electrical connection within an electrical energy storage pack (108) comprising multiple electrical energy storage cells (110), the computer system comprises processing circuitry (102) configured to: determine a voltage drop (114a/b) during a discharge event or a voltage rise (116a/b) during a charging event for at least a first subset (106) and a second subset (107) of the multiple of the electrical energy storage cells (110), determine that the voltage drop (114a) for the first subset (106) of the electrical energy storage cells during the discharge event is larger than the voltage drop (114b) of the second subset (107) of electrical energy storage cells of the multiple electrical energy storage cells or that the voltage rise (116a) for the first subset (106) of the electrical energy storage cells (110) during the charging event is larger than the voltage rise (116b) of second subset (107) of multiple electrical energy storage cells, determine that the voltage of the first subset (106) of electrical energy storage cells converges with the voltage of the second subset (107) of electrical energy storage cells, and provide an output (120) that the first subset of electrical energy storage cells has an intermittent connection (113) to a voltage link (109a).

## Description

### TECHNICAL FIELD

The disclosure relates generally to electrical energy storage systems. In particular aspects, the disclosure relates to a method and computer system for diagnosing an electrical connection within an electrical energy storage pack. The disclosure can be applied to heavy-duty vehicles, such as trucks, buses, and construction equipment, among other vehicle types. The disclosure can also be applied to passenger cars, industrial applications, and stationary applications. Although the disclosure may be described with respect to a particular vehicle, the disclosure is not restricted to any particular vehicle.

### BACKGROUND

Battery packs in the automotive industry include wirebond connects or resistance spot welding or laser welding to connect battery cells in series and/or parallel. The number of connections is typically relatively high and depends on the energy and the power requirements. The quality of the connections is important since poor connections may lead to battery failures.

Current tests for connection quality assessment include contact resistance measurements and pull force tests. However, there is room for improvement with regards to testing connections within battery packs.

### SUMMARY

According to a first aspect of the disclosure, there is provided a computer system for diagnosing an electrical connection within an electrical energy storage pack comprising multiple electrical energy storage cells, the computer system comprises processing circuitry configured to: determine a voltage drop during a discharge event or a voltage rise during a charging event for at least a first subset and a second subset of the multiple of the electrical energy storage cells, determine that the voltage drop for the first subset of the electrical energy storage cells during the discharge event is larger than the voltage drop of second subset of electrical energy storage cells of the multiple electrical energy storage cells or that the voltage rise for the first subset of the electrical energy storage cells during the charging event is larger than the voltage rise of second subset of multiple electrical energy storage cells, determine that the voltage of the first subset of electrical energy storage cells converges with the voltage of the second subset of electrical energy storage cells, and, provide an output that the first subset of electrical energy storage cells has an intermittent connection to a voltage link.

The first aspect of the disclosure may seek to improve testing of connections of cells within an electrical energy storage pack. A technical benefit may be that intermittent connections can be detected during operation of the electrical energy storage pack.

The electrical connections are between cells and the voltage link. The voltage link is connected to a load such as an electric machine.

An intermittent connection is a partial connection which may undesirably switch between being connected and being disconnected, sometimes called a "loose connection".

Optionally in some examples, including in at least one preferred example, the cells in the subsets may be electrically connected in parallel.

Optionally in some examples, including in at least one preferred example, the processing circuitry may be configured to: conclude that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur. The larger voltage drop may be due to increased resistance in the intermittent connection or due to other faulty connections in the electrical energy storage pack. A technical benefit may include improved reliability of the connection test due to the two conditions that both must be fulfilled.

Optionally in some examples, including in at least one preferred example, the processing circuitry may be configured to: perform the diagnosing during operation of the electrical energy storage pack. A technical benefit is that downtime of the device or vehicle that uses the electrical energy storage pack can be avoided or at least reduced.

Optionally in some examples, including in at least one preferred example, the processing circuitry may be further configured to compare the difference in voltage drop between the subsets, or the difference in voltage rise of the subsets of electrical energy storage cells with a reference voltage drop or reference voltage rise. With a suitable reference voltage drop or reference voltage rise false positives can be avoided. That is, the reference can be set such that more than a minor deviation in voltage drop or voltage rise is needed to conclude the presence of an intermittent connection.

Optionally in some examples, including in at least one preferred example, the converging of the voltage may be during a rest stage of the electrical energy storage pack. During a rest stage the load current is at or near zero. A benefit is that the voltages of the cells are allowed to converge.

Optionally in some examples, including in at least one preferred example, the processing circuitry may be further configured to adjust a charging or discharging protocol based on the detected intermittent connection to prevent damage to the electrical energy storage cells. A technical benefit may be to prolong the lifetime of the electrical energy storage cells.

Optionally in some examples, including in at least one preferred example, the processing circuitry may be further configured to provide an output to a user interface to indicate that there is an intermittent connection. A technical benefit may be that an operator is made aware of the intermittent connection and can take appropriate action. This may further prolong the lifetime of the electrical energy storage pack and associated components.

There is further provided a vehicle comprising the computer system.

According to a second aspect of the disclosure, there is provided a computer-implemented method for diagnosing an electrical connection within an electrical energy storage pack comprising multiple electrical energy storage cells, comprising: determining, by processing circuitry of a computer system, a voltage drop during a discharge event or a voltage rise during a charging event for at least a first and a second subset of the multiple of the electrical energy storage cells, determining, by the processing circuitry, that the voltage drop for the first subset of the electrical energy storage cells during the discharge event is larger than the voltage drop of second subset of electrical energy storage cells of the multiple electrical energy storage cells or that the voltage rise for the first subset of the electrical energy storage cells during the charging event is larger than the voltage rise of second subset of multiple electrical energy storage cells, determining, by the processing circuitry, that the voltage of the first subset of electrical energy storage cells converges with the voltage of the second subset of electrical energy storage cells, and providing, by the processing circuitry, an output that the first subset of electrical energy storage cell has an intermittent connection to a voltage link.

The second aspect of the disclosure may seek to improve testing of connections of cells within an electrical energy storage pack. A technical benefit may be that intermittent connections can be detected during operation of the electrical energy storage pack.

Optionally in some examples, including in at least one preferred example, the cells in the subsets are electrically connected in parallel.

Optionally in some examples, including in at least one preferred example, the method may comprise concluding, by the processing circuitry, that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur. The larger voltage drop may be due to increased resistance in the intermittent connection. A technical benefit may include improved reliability of the connection test due to the two conditions that both must be fulfilled.

Optionally in some examples, including in at least one preferred example, the method may comprise performing, by the processing circuitry, the diagnosing during operation of the electrical energy storage pack. A technical benefit is that downtime of the device or vehicle that uses the electrical energy storage pack can be avoided or at least reduced.

Optionally in some examples, including in at least one preferred example, the method may comprise comparing, by the processing circuitry, the difference in voltage drop between the subsets, or the difference in voltage rise of the subsets of electrical energy storage cells with a reference voltage drop or reference voltage rise. With a suitable reference voltage drop or reference voltage rise false positives can be avoided. That is, the reference can be set such that more than a minor deviation in voltage drop or voltage rise is needed to conclude the presence of an intermittent connection.

Optionally in some examples, including in at least one preferred example, the converging of the voltage may be during a rest stage of the electrical energy storage pack. During a rest stage the load current is at or near zero. A benefit is that the voltages of the cells are allowed to converge.

Optionally in some examples, including in at least one preferred example, the method may comprise adjusting, by the processing circuitry, a charging or discharging protocol based on the detected intermittent connection to prevent damage to the electrical energy storage cells. A technical benefit may be to prolong the lifetime of the electrical energy storage cells.

Optionally in some examples, including in at least one preferred example, the method may comprise providing, by the processing circuitry, an output to a user interface to indicate that there is an intermittent connection. A technical benefit may be that an operator is made aware of the intermittent connection and can take appropriate action. This may further prolong the lifetime of the electrical energy storage pack and associated components.

Optionally in some examples, including in at least one preferred example, the method may comprise determining, by the processing circuitry, that the voltage of the first subset of electrical energy storage cells converges with the voltage of the second subset of electrical energy storage cells within a predetermined time duration. If the voltage has not converged within the predetermined time duration, the faulty connection may be completely disconnected and not an intermittent connection. The predetermined time duration may be the rest time of the electrical energy storage pack.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary system diagram of a computer system according to an example.
**FIG. 2** illustrates a wirebond connection between a cell and a voltage link according to an example.
**FIG. 3** is graph illustrating a voltage drop of two subsets of cells according to an example.
**FIG. 4** is a flow chart of an exemplary method for diagnosing an electrical connection within an electrical energy storage pack.
**FIG. 5** is another view of **FIG. 1**, according to an example.
**FIG. 6** is a flow chart of an exemplary method for diagnosing an electrical connection within an electrical energy storage pack according to an example.
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Electrical energy storage packs comprise multiple electrical energy storage cells, e.g., battery cells of a suitable chemistry such as provided by Li-ion cells. To obtain sufficient power and energy, the multiple cells are connected to a busbar linked with a load such that electrical energy can be provided to the load.

The connections can be made using different technologies, such as wire bonding, but other techniques including resistance spot welding or laser welding are also applicable. Regardless of the connection technology, poor connections may lead to electrical energy storage failures and downtime.

Different techniques are available for testing the connections including pull testing and resistance measurements, especially during manufacturing of the electrical energy storage packs. However, existing testing techniques often fail to detect intermittent connections since such connections can be partly conducting. It would further be desirable to test the connections during operation of the electrical energy storage pack. These and other drawbacks are addressed by examples of the present disclosure which are herein described in more detail.

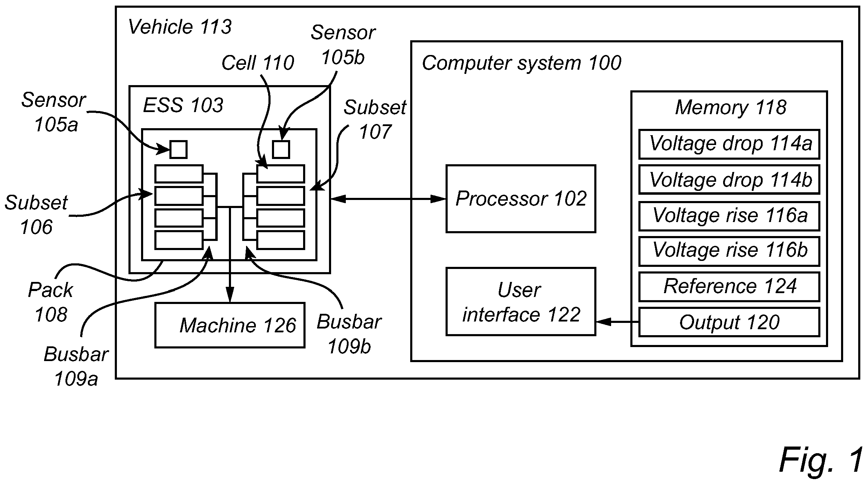

**FIG. 1** is an exemplary system diagram of a computer system 100 for diagnosing an electrical connection within an electrical energy storage pack 108 of an electrical energy storage system 103 according to an example. The electrical energy storage system 103 may comprise multiple electrical energy storage packs 108.

The electrical energy storage pack 108 comprises multiple electrical energy storage cells 110, herein divided into a first subset 106 and a second subset 107 of cells 110.

The cells of the first subset 106 are connected in parallel to a first common voltage link 109a and the cells of the second subset 107 are connected in parallel to a second common voltage link 109b.

A first sensor 105a is arranged to measure a voltage of the first subset 106 and a second sensor 105b is arranged to measure a voltage of the second subset 107.

The computer system comprises processing circuitry 102 configured to measure voltages of the subsets 106 and 107 of electrical energy storage cells 110 of the electrical energy storage pack 108 using the voltage sensors 105a-b.

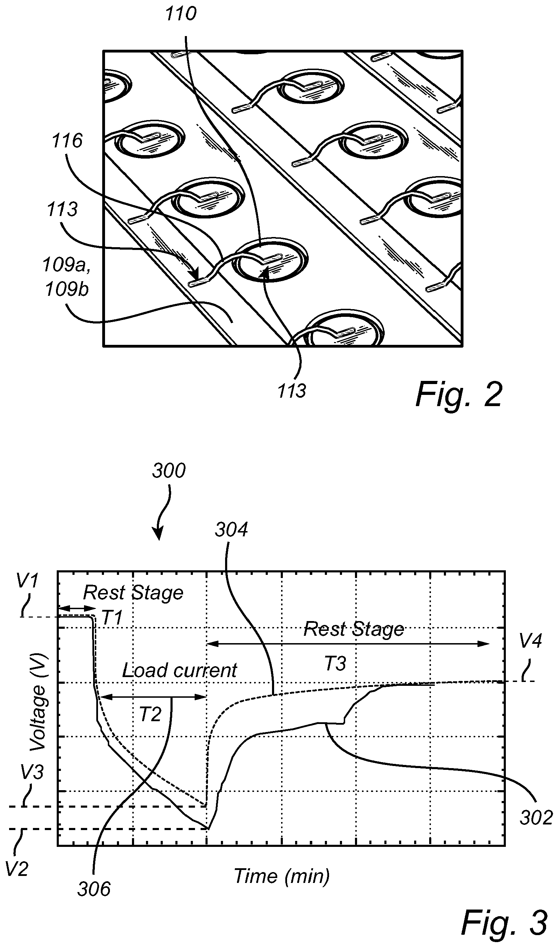

**FIG. 2** illustrates a close-up of a connection 113 between a cell 110 and a voltage link 109a/b. The connection 113 may be a wire bond connection, or similar, such as connections obtained through spot welding or laser welding. Generally, such connections rely on joining the material of a wire 116 and the material of the voltage link 109a/b. The joint 113 is thus a physical joint that mechanically and electrically connects the wire 116 with the metallic voltage link 109a/b, or equally termed "busbar" or voltage bus. That is, the metallic wire 116 is physically joined with the metallic voltage link 109a/b. There is one joint 113 and wire 116 per cell 107.

In case the connection 113, or joint 113 is somewhat loose, there may be an electrical connection between the cell 107 and the voltage link 109a/b but it may be incomplete or "jumpy".

An intermittent connection, or intermittent electrical connection refers to an electrical connection 113 within an electrical energy storage pack, here between the cell 107 and the voltage link 109a/b that is not consistently conductive. This type of connection can alternate between being open (non-conductive) and closed (conductive) due to various factors such as mechanical vibrations, poor solder joints, loose wire bonds, or environmental conditions. Such connections can lead to fluctuating voltage levels during charge and discharge cycles, impacting the performance and reliability of the electrical energy storage cells 110.

In the voltage measurements, the processing circuitry 102 may determine a voltage drop 114a/b during a discharge event or a voltage rise 116a/b during a charging event for at least the first subset 106 and a second subset 107 of the multiple electrical energy storage cells 110. The voltage drop 114a/b is due to a load current discharging the cells 110 and the voltage rise 116a/b is due to added charge during a charging event.

The examples herein are applicable to both the voltage drop 114a/b and the voltage rise 116a/b, but one is considered at a time. Either a voltage drop 114a/b or a voltage rise 116a/b.

The processing circuitry 102 evaluates the voltage drops 114a/b for the first subset 106 of the electrical energy storage cells 110 and the second subset 107 of the electrical energy storage cells 110. Alternatively, the processing circuitry 102 evaluates the voltage rises 116a/b for the first subset 106 of the electrical energy storage cells 110 and the second subset 107 of the electrical energy storage cells 110. The voltage drops 114a/b and voltage rises 116a/b may be stored in memory 118 at least during diagnosing the electrical connection 113.

The processing circuitry 102 determines that the voltage drop 114a for the first subset 106 of the electrical energy storage cells 110 during the discharge event is larger than the voltage drop 114b of the second subset 107 of electrical energy storage cells 110 of the multiple electrical energy storage cells 110. Alternatively, the processing circuitry 102 determines that the voltage rise 116a for the first subset 106 of the electrical energy storage cells 110 during the charging event is larger than the voltage rise 116b of the second subset 107 of multiple electrical energy storage cells 110.

Subsequent to the discharge event or charging event, the processing circuitry 102 determines that the voltage of the first subset 106 of electrical energy storage cells 110 converges with the voltage of the second subset 107 of electrical energy storage cells 110. That is, the processing circuitry 102 monitors the voltages of the subsets 106, 107 using the sensors 105a/b. Preferably, the converging of the voltage is during a rest stage of the electrical energy storage pack 108.

Once the converging of the voltages is confirmed, the processing circuitry 102 provides an output 120 that the first subset 106 of electrical energy storage cells 110 has an intermittent connection to a voltage link 109a.

To provide for more accurate detection of intermittent connections, the processing circuitry 102 may require that both the voltage drop 114a of the first subset 106 of cells 110 is larger than the voltage drop 114b of the second subset 107 of cells 110, and that the voltage of the first subset 106 of cells 110 converges with the voltage of the second subset 107 of electrical energy storage cells 110. Alternatively, in case of a charging event the processing circuitry 102 may require that both the voltage rise 116a of the first subset 106 of cells 110 is larger than the voltage rise 116b of the second subset 107 of cells 110, and that the voltage of the first subset 106 of cells 110 converges with the voltage of the second subset 107 of electrical energy storage cells 110.

Preferably, the processing circuitry 102 is configured to perform the diagnosing during operation of the electrical energy storage pack 108. That is, the steps for detecting an intermittent electrical connection may be performed while the electrical energy storage pack is operative in a device or vehicle 112.

The processing circuitry 102 may provide the output 120 to a user interface 122 to indicate that there is an intermittent connection. The user interface may be a display or speaker, or another messaging interface.

The processing circuitry 102 may have access to voltage drop and voltage rise reference values 124. In order to reduce the number of false positives, the processing circuitry 102 may be configured to compare the difference in voltage drop 114a/b between the subsets 106, 107 with a reference voltage drop 124. The difference in voltage drop should equal or exceed the reference voltage drop for it to be considered a candidate intermittent connection, to be confirmed by the convergence of voltages.

The processing circuitry 102 may alternatively or additionally be configured to compare the difference voltage rise 116a/b of the subsets 106, 107 of electrical energy storage cells with a reference voltage rise 124. The difference in voltage rise should equal or exceed the reference voltage rise for it to be considered a candidate intermittent connection, to be confirmed by the convergence of voltages.

The processing circuitry 102 may be configured to adjust a charging or discharging protocol based on the detected intermittent connection to prevent damage to the electrical energy storage cells 110.

The computer system 100 is in this example comprised in a vehicle 113 comprising a traction electrical energy storage system 103 that provides electrical energy and power to a propulsion system 126 of the vehicle 113 that may comprise an electric machine. The vehicle 113 may thus be a fully electric or partly electric vehicle such as a hybrid electric vehicle.

**FIG.** 3 is a graph 300 illustrating a voltage drop of two subsets of cells according to an example. The solid line 302 is a measured voltage of the first subset 106 of cells 110 and the dashed line 304 is a measured voltage of the second subset 107 of cells 110. This graph 300 illustrates the case of a voltage drop. Analogous methodology applies to a voltage rise.

For a time period T2, subsequent to a rest period T1, a discharge event 306 occurs. During the discharge event 306, a voltage drop 114a from level V1 to level V2 is apparent for the first subset 106 of cells, see curve 302. Similarly, during the discharge event 306, a voltage drop 114b from level V1 to level V3 is apparent for the second subset 107 of cells 110, see curve 304.

The voltage drop 114a of the first subset 106 of cells 110 is the absolute value of the difference between the voltages V1 and V2, that is voltage drop 114a is IV1-V21. The voltage drop 114b of the second subset 107 of cells 110 is the absolute value of the difference between the voltages V1 and V3, that is voltage drop 114b is IV1-V31.

The processing circuitry 102 determines that the voltage drop 114a, |V1-V2|, is larger than the voltage drop 114b, |V1-V3|, and may in some examples compare the difference between the voltage drop 114a and the voltage drop 114b to a reference voltage drop 124 and only proceed when the difference between the voltage drops 114a/b equals or exceeds the reference voltage drop 124. That is, a minor difference in voltage drops which may be present even in the absence of intermittent connections should not mistakenly be considered an intermittent connection.

Subsequent to the discharge event 306, the voltage, the voltage curve 304 of the second subset 107 of cells 110 recovers to a voltage level V4 during a rest period T3. Furthermore, the voltage, see curve 302, of the first subset 106 of electrical energy storage cells 110 converges with the voltage of the second subset 107 of electrical energy storage cells 110. The rest period T3 may be a few minutes up to tens or minutes or even one or a few hours depending on the load current and duration of the discharge event 306. The voltages (V) are typically in the order of a few volts.

The combination of the facts that the voltage drop 114a, |V1-V2|, is larger than the voltage drop 114b, IV1-V31, and the subsequent convergence of voltages during the rest period T3 triggers the processing circuitry 102 to determine and provide an output 120 of that the first subset 106 of electrical energy storage cell has an intermittent connection to a voltage link 109a.

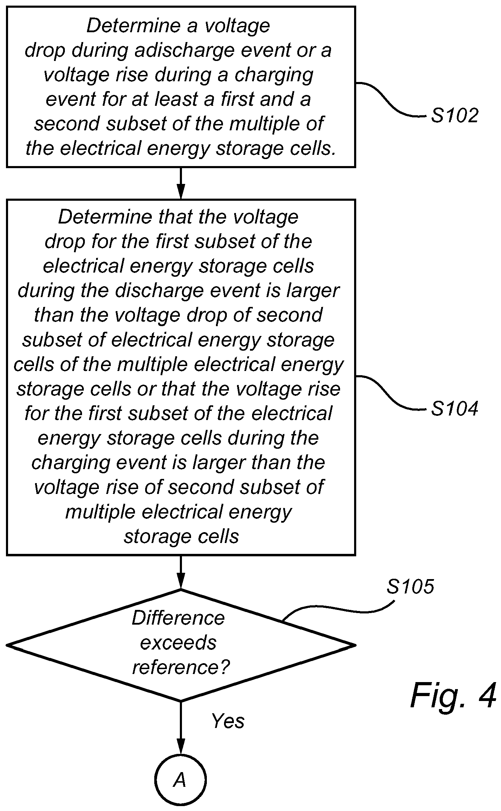

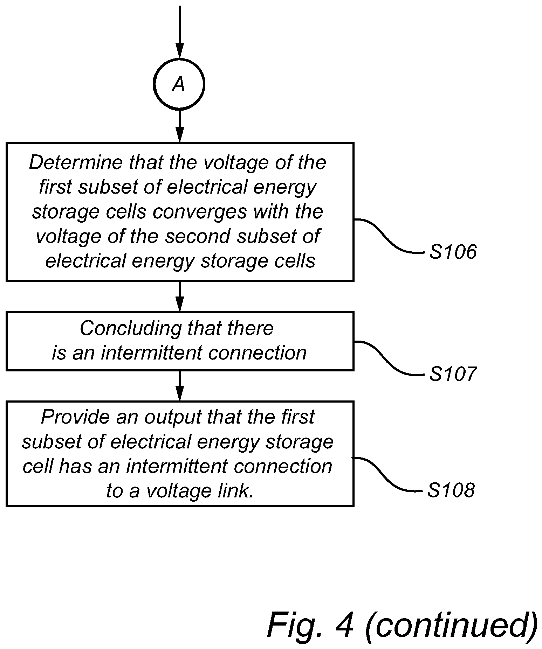

**FIG. 4** is a flow chart of an exemplary method for diagnosing an electrical connection within an electrical energy storage pack 108, preferably during operation of the electrical energy storage pack 108.

In step S102, determining, by processing circuitry 102 of a computer system 100, a voltage drop 114a/b during a discharge event 306 or a voltage rise 116a/b during a charging event for at least a first 106 and a second 107 subset of the multiple of the electrical energy storage cells.

In step S104, determining, by the processing circuitry, that the voltage drop 114a for the first subset 106 of the electrical energy storage cells 110 during the discharge event 306 is larger than the voltage drop of the second subset 107 of electrical energy storage cells 110 of the multiple electrical energy storage cells. In the case of a charge event, determining, in step S 104, that the voltage rise 116a for the first subset 106 of the electrical energy storage cells 110 during the charging event is larger than the voltage rise 116b of second subset 107 of multiple electrical energy storage cells 110.

Optionally, the processing circuitry evaluates, in step S105, if the difference in voltage drop 114a/b between the subsets 106, 107, or the difference in voltage rise 116a/b of the subsets 106, 107 of electrical energy storage cells 110 exceeds a reference 124 voltage drop or reference 124 voltage rise. In the negative, the method ends, however, if the difference exceeds the reference in this optional step, the method proceeds to step S106.

In step S106, determining, by the processing circuitry 102, that the voltage of the first subset 106 of electrical energy storage cells 110 converges, optionally within a predetermined time duration, with the voltage of the second subset 107 of electrical energy storage cells 110. The converging of the voltage may be during a rest stage T3 of the electrical energy storage pack 108.

In step S108, concluding, by the processing circuitry 102, that there is an intermittent connection when both the voltage drop 114a of the first subset 106 of cells is larger than the voltage drop 114b of the second subset 107 of cells, and, when the voltage of the first subset 106 of cells 110 converges with the voltage of the second 107 subset of electrical energy storage cells 110. In the case of a charging event, concluding in step S108, by the processing circuitry 102, that there is an intermittent connection when both the voltage rise 116a of the first subset 106 of cells 110 is larger than the voltage rise 116b of the second subset 107 of cells 110, and when the voltage of the first 106 subset of cells 110 converges with the voltage of the second subset 107 of electrical energy storage cells 110.

In step S108, providing, by the processing circuitry 102, an output indicating that the first subset 106 of electrical energy storage cells 110 has an intermittent connection to a voltage link 109a. The output may be provided to a user interface 122.

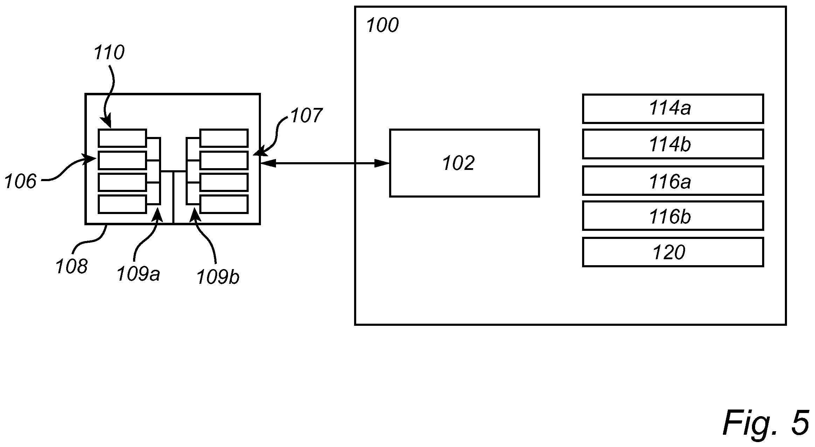

**FIG. 5** is another view of **FIG. 1****,** according to an example. FIG. 5 illustrates a computer system 100 for diagnosing an electrical connection within an electrical energy storage pack 108 comprising multiple electrical energy storage cells 110, the computer system comprises processing circuitry 102 configured to: determine a voltage drop 114a/b during a discharge event or a voltage rise 116a/b during a charging event for at least a first subset 106 and a second subset 107 of the multiple of the electrical energy storage cells, determine that the voltage drop 114a for the first subset 107 of the electrical energy storage cells 110 during the discharge event is larger than the voltage drop 114b of second subset 107 of electrical energy storage cells 110 of the multiple electrical energy storage cells 110 or that the voltage rise 116a for the first subset 106 of the electrical energy storage cells 110 during the charging event is larger than the voltage rise 116b of second subset 107 of multiple electrical energy storage cells, determine that the voltage of the first subset 106 of electrical energy storage cells 110 converges with the voltage of the second subset 107 of electrical energy storage cells 110, and provide an output 120 that the first subset 106 of electrical energy storage cells 110 has an intermittent connection to a voltage link 109a.

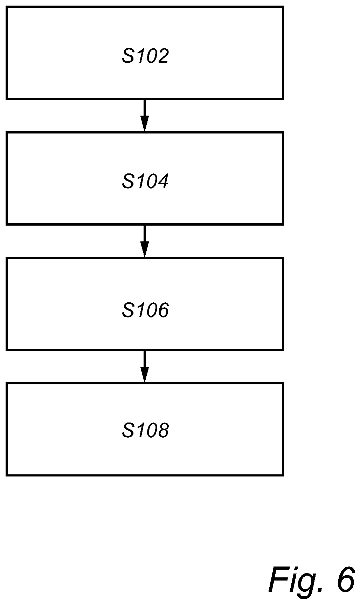

**FIG. 6** is a flow chart of a method for diagnosing an electrical connection within an electrical energy storage pack 108 comprising multiple electrical energy storage cells 110 according to an example.

In step S102, determining, by processing circuitry of a computer system, a voltage drop during a discharge event or a voltage rise during a charging event for at least a first and a second subset of the multiple of the electrical energy storage cells.

In step S104, determining, by the processing circuitry, that the voltage drop for the first subset of the electrical energy storage cells during the discharge event is larger than the voltage drop of second subset of electrical energy storage cells of the multiple electrical energy storage cells or that the voltage rise for the first subset of the electrical energy storage cells during the charging event is larger than the voltage rise of second subset of multiple electrical energy storage cells.

In step S106, determining, by the processing circuitry, that the voltage of the first subset of electrical energy storage cells converges with the voltage of the second subset of electrical energy storage cells.

In step S 108, providing, by the processing circuitry, an output that the first subset of electrical energy storage cell has an intermittent connection to a voltage link.

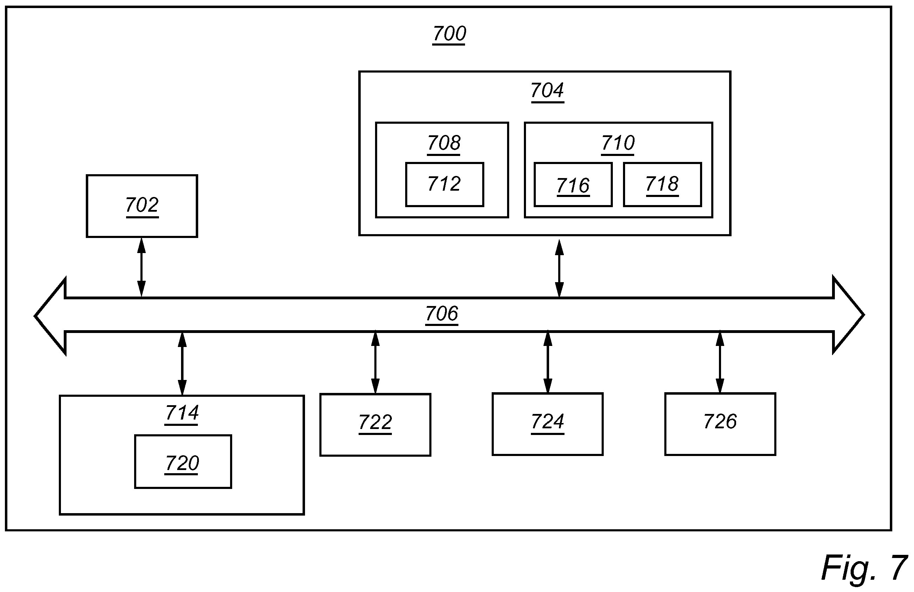

**FIG. 7** is a schematic diagram of a computer system **700** for implementing examples disclosed herein. The computer system **700** is adapted to execute instructions from a computer-readable medium to perform these and/or any of the functions or processing described herein. The computer system **700** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **700** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **700** may comprise at least one computing device or electronic device capable of including firmware, hardware, and/or executing software instructions to implement the functionality described herein. The computer system **700** may include processing circuitry **702** (e.g., processing circuitry including one or more processor devices or control units), a memory **704,** and a system bus **706.** The computer system **700** may include at least one computing device having the processing circuitry **702.** The system bus **706** provides an interface for system components including, but not limited to, the memory **704** and the processing circuitry **702.** The processing circuitry **702** may include any number of hardware components for conducting data or signal processing or for executing computer code stored in memory **704.** The processing circuitry **702** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **702** may further include computer executable code that controls operation of the programmable device.

The system bus **706** may be any of several types of bus structures that may further interconnect to a memory bus (with or without a memory controller), a peripheral bus, and/or a local bus using any of a variety of bus architectures. The memory **704** may be one or more devices for storing data and/or computer code for completing or facilitating methods described herein. The memory **704** may include database components, object code components, script components, or other types of information structure for supporting the various activities herein. Any distributed or local memory device may be utilized with the systems and methods of this description. The memory **704** may be communicably connected to the processing circuitry **702** (e.g., via a circuit or any other wired, wireless, or network connection) and may include computer code for executing one or more processes described herein. The memory **704** may include non-volatile memory **708** (e.g., read-only memory (ROM), erasable programmable read-only memory (EPROM), electrically erasable programmable read-only memory (EEPROM), etc.), and volatile memory **710** (e.g., random-access memory (RAM)), or any other medium which can be used to carry or store desired program code in the form of machine-executable instructions or data structures and which can be accessed by a computer or other machine with processing circuitry **702.** A basic input/output system (BIOS) **712** may be stored in the non-volatile memory **708** and can include the basic routines that help to transfer information between elements within the computer system **700.**

The computer system **700** may further include or be coupled to a non-transitory computer-readable storage medium such as the storage device **714,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **714** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **714** and/or in the volatile memory **710,** which may include an operating system **716** and/or one or more program modules **718.** All or a portion of the examples disclosed herein may be implemented as a computer program **720** stored on a transitory or non-transitory computer-usable or computer-readable storage medium (e.g., single medium or multiple media), such as the storage device **714,** which includes complex programming instructions (e.g., complex computer-readable program code) to cause the processing circuitry **702** to carry out actions described herein. Thus, the computer-readable program code of the computer program **720** can comprise software instructions for implementing the functionality of the examples described herein when executed by the processing circuitry **702.** In some examples, the storage device **714** may be a computer program product (e.g., readable storage medium) storing the computer program **720** thereon, where at least a portion of a computer program **720** may be loadable (e.g., into a processor) for implementing the functionality of the examples described herein when executed by the processing circuitry **702.** The processing circuitry **702** may serve as a controller or control system for the computer system **700** that is to implement the functionality described herein.

The computer system **700** may include an input device interface **722** configured to receive input and selections to be communicated to the computer system **700** when executing instructions, such as from a keyboard, mouse, touch-sensitive surface, etc. Such input devices may be connected to the processing circuitry **702** through the input device
interface **722** coupled to the system bus **706** but can be connected through other interfaces, such as a parallel port, an Institute of Electrical and Electronic Engineers (IEEE) 1394 serial port, a Universal Serial Bus (USB) port, an IR interface, and the like. The computer system **700** may include an output device interface **724** configured to forward output, such as to a display, a video display unit (e.g., a liquid crystal display (LCD) or a cathode ray tube (CRT)). The computer system **700** may include a communications interface **726** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system for diagnosing an electrical connection within an electrical energy storage pack comprising multiple electrical energy storage cells, the computer system comprises processing circuitry configured to: determine a voltage drop during a discharge event or a voltage rise during a charging event for at least a first subset and a second subset of the multiple of the electrical energy storage cells, determine that the voltage drop for the first subset of the electrical energy storage cells during the discharge event is larger than the voltage drop of second subset of electrical energy storage cells of the multiple electrical energy storage cells or that the voltage rise for the first subset of the electrical energy storage cells during the charging event is larger than the voltage rise of second subset of multiple electrical energy storage cells, determine that the voltage of the first subset of electrical energy storage cells converges with the voltage of the second subset of electrical energy storage cells, and provide an output that the first subset of electrical energy storage cells has an intermittent connection to a voltage link.

Example 2: The computer system of example 1, where the cells in the subsets are electrically connected in parallel.

Example 3: The computer system of any of examples 1-2, the processing circuitry is configured to: conclude that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur.

Example 4: The computer system of any of examples 1-3, the processing circuitry is configured to perform the diagnosing during operation of the electrical energy storage pack.

Example 5: The computer system of any of examples 1-4, wherein the processing circuitry is further configured to compare the difference in voltage drop between the subsets, or the difference in voltage rise of the subsets of electrical energy storage cells with a reference voltage drop or reference voltage rise.

Example 6: The computer system of any of examples 1-5, wherein the converging of the voltage is during a rest stage of the electrical energy storage pack.

Example 7: The computer system of any of examples 1-6, wherein the processing circuitry is further configured to adjust a charging or discharging protocol based on the detected intermittent connection to prevent damage to the electrical energy storage cells.

Example 8: The computer system of any of examples 1-7, wherein the processing circuitry is further configured to provide an output to a user interface to indicate that there is an intermittent connection.

Example 9: A vehicle comprising the computer system of any one of examples 1-8.

Example 10: A computer-implemented method for diagnosing an electrical connection within an electrical energy storage pack comprising multiple electrical energy storage cells, comprising: determining, by processing circuitry of a computer system, a voltage drop during a discharge event or a voltage rise during a charging event for at least a first and a second subset of the multiple of the electrical energy storage cells, determining, by the processing circuitry, that the voltage drop for the first subset of the electrical energy storage cells during the discharge event is larger than the voltage drop of second subset of electrical energy storage cells of the multiple electrical energy storage cells or that the voltage rise for the first subset of the electrical energy storage cells during the charging event is larger than the voltage rise of second subset of multiple electrical energy storage cells, determining, by the processing circuitry, that the voltage of the first subset of electrical energy storage cells converges with the voltage of the second subset of electrical energy storage cells, and providing, by the processing circuitry, an output that the first subset of electrical energy storage cell has an intermittent connection to a voltage link.

Example 11: The method of example 10, where the cells in the subsets are electrically connected in parallel.

Example 12: The method of any of examples 10-11, comprising: concluding, by the processing circuitry, that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur.

Example 13: The method of any of examples 10-12, comprising: performing, by the processing circuitry, the diagnosing during operation of the electrical energy storage pack.

Example 14: The method of any of examples 10-13, comprising: comparing, by the processing circuitry, the difference in voltage drop between the subsets, or the difference in voltage rise of the subsets of electrical energy storage cells with a reference voltage drop or reference voltage rise.

Example 15: The method of any of examples 10-14, wherein the converging of the voltage is during a rest stage of the electrical energy storage pack.

Example 16: The method of any of examples 10-15, comprising: adjusting, by the processing circuitry, a charging or discharging protocol based on the detected intermittent connection to prevent damage to the electrical energy storage cells.

Example 17: The method of any of examples 10-16, comprising: providing, by the processing circuitry, an output to a user interface to indicate that there is an intermittent connection.

Example 18: The method of any of examples 10-17, comprising:

determining, by the processing circuitry, that the voltage of the first subset of electrical energy storage cells converges with the voltage of the second subset of electrical energy storage cells within a predetermined time duration.

Example 19: A computer program product comprising program code for performing, when executed by the processing circuitry, the method of any of examples 10-18.

Example 20: A non-transitory computer-readable storage medium comprising instructions, which when executed by the processing circuitry, cause the processing circuitry to perform the method of any of examples 10-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) for diagnosing an electrical connection within an electrical energy storage pack (108) comprising multiple electrical energy storage cells (110), the computer system comprises processing circuitry (102) configured to:
determine a voltage drop (114a/b) during a discharge event or a voltage rise (116a/b) during a charging event for at least a first subset (106) and a second subset (107) of the multiple of the electrical energy storage cells (110),
determine that the voltage drop (114a) for the first subset (106) of the electrical energy storage cells during the discharge event is larger than the voltage drop (114b) of the second subset (107) of electrical energy storage cells of the multiple electrical energy storage cells or that the voltage rise (116a) for the first subset (106) of the electrical energy storage cells (110) during the charging event is larger than the voltage rise (116b) of second subset (107) of multiple electrical energy storage cells,
determine that the voltage of the first subset (106) of electrical energy storage cells converges with the voltage of the second subset (107) of electrical energy storage cells, and
provide an output (120) that the first subset of electrical energy storage cells has an intermittent connection (113) to a voltage link (109a).

2. The computer system of claim 1, where the cells in the subsets are electrically connected in parallel.

3. The computer system of any of claims 1-2, the processing circuitry is configured to:
conclude that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur.

4. The computer system of any of claims 1-3, the processing circuitry is configured to perform the diagnosing during operation of the electrical energy storage pack.

5. The computer system of any of claims 1-4, wherein the processing circuitry is further configured to compare the difference in voltage drop between the subsets, or the difference in voltage rise of the subsets of electrical energy storage cells with a reference voltage drop or reference voltage rise.

6. The computer system of any of claims 1-5, wherein the converging of the voltage is during a rest stage of the electrical energy storage pack.

7. The computer system of any of claims 1-6, wherein the processing circuitry is further configured to adjust a charging or discharging protocol based on the detected intermittent connection to prevent damage to the electrical energy storage cells.

8. The computer system of any of claims 1-7, wherein the processing circuitry is further configured to provide an output to a user interface to indicate that there is an intermittent connection.

9. A vehicle comprising the computer system of any one of claims 1-8.

10. A computer-implemented method for diagnosing an electrical connection within an electrical energy storage pack (108) comprising multiple electrical energy storage cells (110), comprising:
determining (S102), by processing circuitry (102) of a computer system (100), a voltage drop (114a/b) during a discharge event or a voltage rise (116a/b) during a charging event for at least a first and a second subset of the multiple of the electrical energy storage cells,
determining (S104), by the processing circuitry (102), that the voltage drop (114a) for the first subset (106) of the electrical energy storage cells during the discharge event is larger than the voltage drop (114b) of second subset (107) of electrical energy storage cells of the multiple electrical energy storage cells or that the voltage rise (116a) for the first subset (106) of the electrical energy storage cells during the charging event is larger than the voltage rise (116b) of second subset (107) of multiple electrical energy storage cells,
determining (S 106), by the processing circuitry, that the voltage of the first subset (106) of electrical energy storage cells converges with the voltage of the second subset (107) of electrical energy storage cells, and
providing (S108), by the processing circuitry, an output (120) that the first subset of electrical energy storage cell has an intermittent connection to a voltage link.

11. The method of claim 10, comprising:
concluding, by the processing circuitry, that there is an intermittent connection only when both the voltage drop or the voltage rise of the first subset of cells is larger than the voltage drop or voltage rise of the second subset of cells, and when the voltage of the first subset of cells converges with the voltage of the second subset of electrical energy storage cells occur.

12. The method of any of claims 10-11, comprising:
performing, by the processing circuitry, the diagnosing during operation of the electrical energy storage pack.

13. The method of any of claims 10-12, comprising:
determining, by the processing circuitry, that the voltage of the first subset of electrical energy storage cells converges with the voltage of the second subset of electrical energy storage cells within a predetermined time duration.

14. A computer program product comprising program code for performing, when executed by the processing circuitry, the method of any of claims 10-13.

15. A non-transitory computer-readable storage medium comprising instructions, which when executed by the processing circuitry, cause the processing circuitry to perform the method of any of claims 10-13.
